# EUROPEAN PATENT APPLICATION

(11) **EP 3 147 632 A1**
(43) Date of publication of application: **29.03.2017**
(21) Application number: 14892493.9
(22) Date of filing: 23.09.2014
(51) Int. Cl.: G01D 21/00

(54) **METHOD, SYSTEM AND APPARATUS FOR DETECTING BLOCKAGE OF DUST FILTER**

(30) Priority: 21.05.2014 CN 201410217013
(71) Applicant: ZTE Corporation, Shenzhen, Guangdong 518057 (CN)
(72) Inventor: LI, Tingyong, Shenzhen Guangdong 518057 (CN)
(74) Representative: Potter Clarkson LLP
(86) International application number: PCT/CN2014/087145
(87) International publication number: WO 2015/176439

(57) **Abstract**

A method, a system and an apparatus for detecting blockage of a dust filter. The method comprises: detecting a first rotational speed of a fan enabling a device temperature to reach a target value at a current ambient temperature; determining a second rotational speed of the fan required for enabling the device temperature to reach the target value with a specific degree of blockage of a dust filter at the current ambient temperature; determining a difference between the first rotational speed and the second rotational speed, and obtaining a rotational speed change magnitude according to the difference; and determining a current degree of blockage of the dust filter according to the rotational speed change magnitude.

## Description

### TECHNICAL FIELD

The present disclosure relates to the field of heat dissipation technology for communication devices and, particularly, to a method, a system and an apparatus for detecting blockage of a dust filter.

### BACKGROUND

Generally, heat is generated during operation of electronic devices, causing the device temperature to rise. Since an excessive device temperature may affect performance of the device, most of the electronic devices are provided with cooling system. A commonly used cooling system is of air cooling type, which in fact is realized by forced heat convection. A fan constantly blows cool air into the device filled with hot air therein, creating a temperature difference that causes the heat to pass from a region with a high temperature to another region with a low temperature. Accordingly, the hot air in the device flows out, enabling the device temperature to be reduced. Introduction of dust is inevitable during operation of the air cooling system, which may affect work of the device to a certain extent and even erode the device. In order to reduce impact of the dust on the device as well as corrosion, a dust filter is generally provided between the fan and the device for dustproof purpose, especially for those devices in a communication system with high reliability requirements. Dust deposition on the filter may affect cooling performance of the device and, thus, deteriorate reliability of device.

Regular testing and maintenance of the dust filter, which cost a relatively great investment in labor, are required by existing communication devices, so as to ensure normal operation of the devices. Considering diversity of operating environment for the devices, blockage degree of the dust filter varies. Regular maintenance does not guarantee that the dust filter is always in the normal state. Therefore, it is necessary to provide a method for detecting blockage of the dust filter, so as to timely alert and remind the user to carry out maintenance work when the dust filer is blocked.

Following method is mainly adopted in related art to detect blockage degree of a dust filter: collecting rotational speeds of a fan and wind speed parameters under the rotational speeds, acquiring wind resistance characteristic parameter according to the rotational speeds and wind speed parameters under the rotational speeds; determining blockage degree of the dust filter based on the wind resistance characteristic parameter and an alerting threshold and, further, generating an alarm of dust filter, so as to remind the user to carry out maintenance work. However, this method is only applicable to a cooling system with a speed-fixed fan, but is not applicable to a cooling system with a speed-adjustable fan. As to the cooling system with the speed-adjustable fan, a rotational speed of the fan may be adjusted based on a device temperature. Accordingly, the rotational speed of the fan is variable and, thus, the wind resistance characteristic parameter varies depending on the rotational speed, so it is unable to effectively identify blockage of the dust filter and a false alarm may be generated, causing a limited scope of application. In view of that the above method is not applicable to the cooling system with a speed-adjustable fan, those skilled in the art also proposed the use of laser to detect the dust filter. The laser may be attenuated as passing through the dust filter, and the attenuation degree of laser is related to a thickness of dust on the filter. Accordingly, it is able to determine blockage status of the dust filter by detecting light intensity of the laser transmitting through the dust filter and, further, generate an alarm of dust filter, so as to remind the user to carry out maintenance work. However, the use of laser transmission detection technology requires additional hardware devices of laser emission and detection, which raise system complexity, take up system space, increase costs and, thus, also cause a greatly limited scope of application. Therefore, a simple and low cost method for detecting blockage of dust filter, which can be suitable for the cooling system with a speed-adjustable fan has not yet been developed in related art.

### SUMMARY

Embodiments of the present disclosure provide method, a system and an apparatus for detecting blockage of a dust filter, which overcome problems of the method for detecting blockage of dust filter in related art including great complexity, high cost and limited scope of application.

In order to overcome those problems described above, embodiments of the present disclosure provide a method for detecting blockage of a dust filter, including: detecting a first rotational speed of a fan enabling a device temperature to reach a target value under a current ambient temperature; determining a second rotational speed of the fan, with a certain blockage degree of the dust filter, required for enabling the device temperature to reach the target value under the current ambient temperature; determining a difference between the first rotational speed and the second rotational speed, so as to obtain a variation magnitude of rotational speed according to the difference; and determining a current blockage degree of the dust filter according to the variation magnitude of rotational speed.

In an embodiment, before the detecting a first rotational speed of a fan enabling a device temperature to reach a target value under a current ambient temperature, the method includes: detecting rotational speeds of the fan, with the certain blockage degree of the dust filter, required for enabling the device temperature to reach the target value under different ambient temperatures, so as to obtain a first correspondence between the ambient temperatures and the rotational speeds of the fan; and
the determining a second rotational speed of the fan, with a certain blockage degree of the dust filter, required for enabling the device temperature to reach the target value under the current ambient temperature includes: determining, according to the current ambient temperature and the first correspondence, a rotational speed of the fan, with the certain blockage degree of the dust filter, required for enabling the device temperature to reach the target value as the second rotational speed.

In an embodiment, the certain blockage degree is any one selected from a range from clean to complete blockage.

In an embodiment, the detecting a first rotational speed of a fan enabling a device temperature to reach a target value under a current ambient temperature includes:
setting an initial rotational speed of the fan, adjusting, according to a detected device temperature, a rotational speed of the fan gradually from the initial rotational speed until the device temperature is less than or equal to the target value, and determining the adjusted rotational speed of the fan as the first rotational speed.

In an embodiment, the setting an initial rotational speed of the fan includes: setting a fixed value as the initial rotational speed; or determining, according to the current ambient temperature and the first correspondence, a rotational speed of the fan, with a clean dust filter, required for enabling the device temperature to reach the target value as the initial rotational speed of the fan.

In an embodiment, before the determining a current blockage degree of the dust filter according to the variation magnitude of rotational speed, the method includes: setting a first threshold of severe blockage for different ambient temperatures;
the determining a current blockage degree of the dust filter according to the variation magnitude of rotational speed includes: detecting whether the variation magnitude of rotational speed is greater than or equal to the first threshold of severe blockage and, if yes, determining that the blockage degree of the dust filter is severe.

In an embodiment, before the determining a current blockage degree of the dust filter according to the variation magnitude of rotational speed, the method includes: setting second thresholds of severe blockage respectively for different ambient temperatures, so as to obtain a second correspondence between the ambient temperatures and the second thresholds of severe blockage;
the determining a current blockage degree of the dust filter according to the variation magnitude of rotational speed includes: determining a second threshold of severe blockage according to the current ambient temperature and the second correspondence, detecting whether the variation magnitude of rotational speed is greater than or equal to the determined second threshold of severe blockage and, if yes, determining that the blockage degree of the dust filter is severe.

In an embodiment, before the detecting a first rotational speed of a fan enabling a device temperature to reach a target value under a current ambient temperature, the method includes: detecting an actual rotational speed of the fan at a time interval under the current ambient temperature;
after the determining a second rotational speed of the fan, with a certain blockage degree of the dust filter, required for enabling the device temperature to reach the target value under the current ambient temperature, the method includes: determining a difference between the actual rotational speed of the fan and the second rotational speed, so as to obtain a variation magnitude of actual rotational speed; detecting whether the variation magnitude of actual rotational speed is greater than or equal to the second threshold of severe blockage corresponding to the current ambient temperature and, if yes, determining that the blockage of the dust filter is severe.

Embodiments of the disclosure also provide a system for detecting blockage of a dust filter, including: a first rotational speed determination module, a second rotational speed determination module, a variation magnitude of rotational speed determination module, and a blockage degree determination module;
the first rotational speed determination module is configured to detect a first rotational speed of a fan enabling a device temperature to reach a target value under a current ambient temperature;
the second rotational speed determination module is configured to determine a second rotational speed of the fan, with a certain blockage degree of the dust filter, required for enabling the device temperature to reach the target value under the current ambient temperature;
the variation magnitude of rotational speed determination module is configured to determine a difference between the first rotational speed and the second rotational speed, so as to obtain a variation magnitude of rotational speed according to the difference;
the blockage degree determination module is configured to determine a current blockage degree of the dust filter according to the variation magnitude of rotational speed.

In an embodiment, the system further includes a first correspondence determination module configured to detect rotational speeds of the fan, with the certain blockage degree of the dust filter, required for enabling the device temperature to reach the target value under different ambient temperatures, so as to obtain a first correspondence between the ambient temperatures and the rotational speeds of the fan;
the second rotational speed determination module includes a second rotational speed determination sub-module configured to determine, according to the current ambient temperature and the first correspondence, a rotational speed of the fan, with the certain blockage degree of the dust filter, required for enabling the device temperature to reach the target value as the second rotational speed.

In an embodiment, the first rotational speed determination module includes an initial rotational speed setting sub-module and a rotational speed adjusting sub-module;
the initial rotational speed setting sub-module is configured to set an initial rotational speed of the fan;
the rotational speed adjusting sub-module is configured to adjust, according to a detected device temperature, a rotational speed of the fan gradually from the initial rotational speed until the device temperature is less than or equal to the target value, and determine the adjusted rotational speed of the fan as the first rotational speed.

In an embodiment, the initial rotational speed setting sub-module includes a first initial rotational speed setting sub-module or a second initial rotational speed setting sub-module, the first initial rotational speed setting sub-module is configured to set a fixed value as the initial rotational speed; and the second initial rotational speed setting sub-module is configured to determine, according to the current ambient temperature and the first correspondence, a rotational speed of the fan, with a clean dust filter, required for enabling the device temperature to reach the target value as the initial rotational speed of the fan.

In an embodiment, the system further includes a first threshold of severe blockage setting module configured to set a first threshold of severe blockage for different ambient temperatures;
the blockage degree determination module includes a first determination module configured to detect whether the variation magnitude of rotational speed is greater than or equal to the first threshold of severe blockage and, if yes, determine that the blockage degree of the dust filter is severe.

In an embodiment, the system further includes a second threshold of severe blockage setting module configured to set second thresholds of severe blockage respectively for different ambient temperatures, so as to obtain a second correspondence between the ambient temperatures and the second thresholds of severe blockage;
the blockage degree determination module includes a second determination module configured to determine a second threshold of severe blockage according to the current ambient temperature and the second correspondence, detect whether the variation magnitude of rotational speed is greater than or equal to the determined second threshold of severe blockage and, if yes, determine that the blockage degree of the dust filter is severe.

Embodiment of the disclosure also provide an apparatus for detecting blockage of a dust filter, including: an ambient temperature detection module, a device temperature detection module, a rotational speed detection module, a processing module, and a memory module; the ambient temperature detection module is configured to detect a current ambient temperature; the device temperature detection module is configured to detect a device temperature; the rotational speed detection module is configured to detect a rotational speed of a fan; the device temperature detection module is further configured to notify the processing module when the detected device temperature reaches a target value; and the processing module is configured to acquire a current rotational speed from the rotational speed detection module, and set the current rotational speed as a first rotational speed; the memory module is configured to store a correspondence between a second rotational speed and an ambient temperature, the second rotational speed being a rotational speed of the fan, with a certain blockage degree of the dust filter, required for enabling the device temperature to reach the target value; the processing module is further configured to acquire the current ambient temperature from the ambient temperature detection module, and acquire a second rotational speed of the fan corresponding to the current ambient temperature from the memory module; the processing module is further configured to determine a difference between the first rotational speed and the second rotational speed, obtain a variation magnitude of rotational speed according to the difference, and determine a current blockage degree of the dust filter according to the variation magnitude of rotational speed.

In an embodiment, the memory module is further configured to store a first threshold of severe blockage and/or a second threshold of severe blockage; the first threshold of severe blockage is set as a same value for different ambient temperatures; the processing module is further configured to acquire the first threshold of severe blockage from the memory module, and detect whether the variation magnitude of rotational speed is greater than or equal to the first threshold of severe blockage and, if yes, determine that the blockage degree of the dust filter is severe. The second threshold of severe blockage is set as values corresponding to different ambient temperatures; the processing module is further configured to acquire a second threshold of severe blockage corresponding to the current ambient temperature from the memory module after acquiring the current ambient temperature, and detect whether the variation magnitude of rotational speed is greater than or equal to the determined second threshold of severe blockage and, if yes, determine that the blockage degree of the dust filter is severe.

According to the method and system for detecting blockage of dust filter provided by embodiments of the disclosure, problems of the method for detecting blockage of dust filter applied to the cooling system with speed-adjustable fan in related art, including great complexity, high cost and limited scope of application, can be overcome. The method proposed in embodiments of the disclosure is mainly implemented by comparing actually adjusted rotational speed of the fan with a rotational speed of the fan having a certain blockage degree of a dust filter to determine blockage of the dust filter. According to the method proposed by the embodiments of the disclosure, blockage status of the dust filter can be determined by only measuring the first rotational speed of the fan and calculating the difference between the first rotational speed and the second rotational speed without any bulky and costly device. Therefore, the method provided by embodiments of the disclosure is simple in structure, low in cost and wide in its application scope.

### BRIEF DESCRIPTION OF THE DRAWINGS

FIG. 1 is a flowchart illustrating a method for detecting blockage of dust filter according to a first embodiment of the present disclosure.
FIG. 2 is a flowchart illustrating a method for detecting blockage of dust filter according to a second embodiment of the present disclosure.
FIG. 3 is a flowchart illustrating a method for detecting blockage of dust filter according to a third embodiment of the present disclosure.
FIG. 4 is a block diagram illustrating an apparatus for detecting blockage of dust filter according to a fourth embodiment of the present disclosure.
FIG. 5 is a block diagram illustrating another apparatus for detecting blockage of dust filter according to the fourth embodiment of the present disclosure.
FIG. 6 is a block diagram illustrating still another apparatus for detecting blockage of dust filter according to the fourth embodiment of the present disclosure.
FIG. 7 is a block diagram illustrating yet another apparatus for detecting blockage of dust filter according to the fourth embodiment of the present disclosure.
FIG. 8 is a block diagram illustrating an apparatus for detecting blockage of dust filter according to a fifth embodiment of the present disclosure.

### DETAILED DESCRIPTION

Embodiments of the disclosure will be described in detail with reference to drawings. It should be noted that features in different embodiments of the disclosure can be combined as proper when no conflict exists.

### The First Embodiment

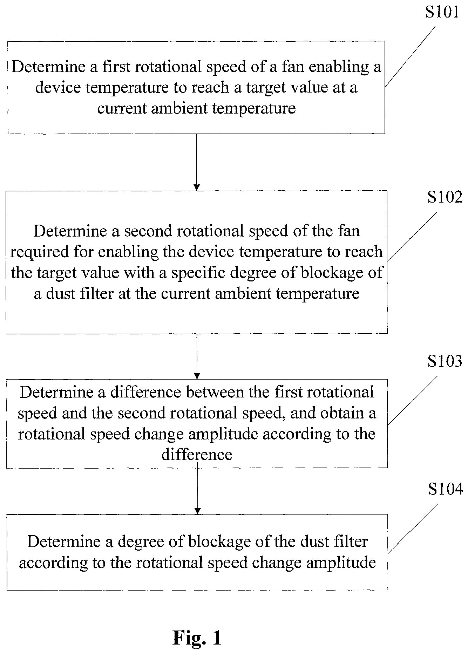

The embodiment provides a method for detecting blockage of a dust filter which, as shown in Fig. 1, includes following steps.

In step S101, a first rotational speed of a fan enabling a device temperature to reach a target value under a current ambient temperature is detected.

In the present embodiment, the target value refers to a value of the device temperature, that is, a target temperature or a target temperature range that the device is intended to reach. For example, a current temperature of the device is 60 degrees. At this time, an air cooling system is turned on for enabling the device temperature to reach 20 degrees. Then, the target value of the device temperature is 20 degrees. If the device temperature is desired to reach a range of 20-30 degrees, then the target value of the device temperature is 20-30 degrees. The present embodiment is directed to a same device. In related art, however, since the target values for the same device are the same, the present embodiment is described with the target value of the same device. The present embodiment is also applicable to a device whose target value is adjustable.

In the present embodiment, the first rotational speed of the fan enabling the device temperature to reach the target value refers to a rotational speed of the fan when the device temperature, reduced by an air cooling system in actual application, drops from above the target value to below or equal to the target value for the first time.

In step S102, a second rotational speed of the fan, with a certain blockage degree of the dust filter, required for enabling the device temperature to reach the target value under the current ambient temperature is determined.

The certain blockage degree of the dust filter refers to any degree selected in a range from clean to complete blockage and including both clean and complete blockage. Therefore, the certain blockage degree of the dust filter may include conditions such as clean, slight blockage, severe blockage, complete blockage and the like. When the determined second rotational speed refers to a rotational speed of the fan, with a severe blockage of the dust filter, required for enabling the device temperature to reach the target value under the current ambient temperature and, if the first rotational speed of the fan is lower than the second rotational speed, it indicates that the blockage degree of the dust filter is less than severe blockage.

In steps S103, a difference between the first rotational speed and the second rotational speed is determined so as to obtain a variation magnitude of rotational speed according to the difference.

In this embodiment, the determination of the second rotation speed may be performed experimentally. For example, rotational speeds of the fan, with the certain blockage degree of the dust filter, required for enabling the device temperature to reach the target value under various ambient temperatures may be detected, so as to obtain a first correspondence between the ambient temperatures and the rotational speeds of the fan. Then, according to the current ambient temperature and the first correspondence, a rotational speed of the fan, with the certain blockage degree of the dust filter, required for enabling the device temperature to reach the target value may be determined as the second rotational speed.

The first correspondence may be expressed in a number of forms, for example, in the form of a table. Referring to Table 1, the data in Table 1 are measured when the target value of the device temperature is 20 degrees.

**Table 1**

| Ambient Temperature (degree) | Rotational Speed of the Fan (r/s) |
|---|---|
| 23 | 10 |
| 26 | 12 |
| 30 | 14 |

In order to enrich content of the table, rotational speeds of the fan required for enabling the device temperature to reach different target values under different ambient temperature may be further detected, so as to obtain a correspondence of the ambient temperatures, the target values of device temperature and the rotational speeds of fan, as shown in following table.

**Table 2**

| Ambient Temperature (degree) | Target Values of Device Temperature (degree) | Rotational Speed of the Fan (r/s) |
|---|---|---|
| 23 | 20 | 10 |
| 27 | 22 | 12 |
| 35 | 24 | 14 |

In the present embodiment, the correspondence between the ambient temperature and the rotational speed of fan, required for enabling the device temperature to reach the target value, is measured experimentally or by inference from device parameters or set artificially. If it is measured experimentally, assuming the dust filter is clean, for example, the correspondence may be determined in following manner. The device, with its dust filter being cleaned, can be placed in a space with adjustable temperature. A table may be created with its content including the ambient temperature and the rotational speed of fan required for enabling the device temperature to reach the target value (the target value of device temperature is generally fixed for a same device, so the target value of device temperature is a fixed value in this example). The ambient temperature ranges from 23 to 55 degrees, and the target value of device temperature is set to 20 degrees. Then, the ambient temperature is adjusted to a certain value, a rotational speed of the fan enabling the device temperature to reach the target value is detected and filled into the table. The rotational speed of fan enabling the device temperature to reach the target value is detected every other degree from 23 degrees to 55 degrees of the ambient temperature.

Since the first correspondence includes the relationship between the ambient temperature, the target value of device temperature and the rotational speed of fan required for enabling the device temperature to reach the target value, after the current ambient temperature and the target value of device temperature are determined, a rotational speed of fan can be set according to the correspondence, which can be set as an initial rotation speed for the fan. If the dust filter is clean, the fan can enable the device temperature to reach the target value with the initial rotational speed. If the dust filter is blocked, the cooling effect may be affected. Accordingly, even the fan blows cold air to the device with the initial rotational speed, the device temperature will not be lower than or equal to the target value. Then, the rotational speed of fan may be adjusted according to the detected device temperature and the target value such that the air blown onto the device can enable the device temperature to be lower than or equal to the target value.

In step S104, a blockage degree of the dust filter is determined according to the variation magnitude of rotational speed.

Determination of the blockage degree relates to setting of the specific blockage degree of the dust filter. For example, when the specific blockage degree is set to be slight blockage, it is only necessary to judge whether the difference between the first rotational speed and the second rotational speed is less than zero to determine the blockage degree of the dust filter. When the difference between the first rotational speed and the second rotational speed is less than zero, the first rotational speed is smaller than the second rotational speed, indicating that the blockage degree of the dust filter is lower than the slight blockage and no cleaning is required. Such a determination is very simple, but it is not easy to determine the blockage degree directly for a case of above zero. When the specific blockage degree is set to be severe blockage, it is only necessary to determine whether the difference between the first rotational speed and the second rotational speed is greater than zero to determine the blockage degree of the dust filter. When the difference between the first rotational speed and the second rotational speed is greater than zero, the first rotational speed is larger than the second rotational speed, indicating that the blockage degree of the dust filter is greater than the severe blockage and the dust filter should be cleaned. For such a determination, it is not easy to determine the blockage degree directly for a case of below zero.

In order to determine the blockage degree more accurately, it is also possible to set blockage thresholds and determine the blockage degree of the dust filter by comparing the difference between the first rotational speed and the second rotational speed (i.e., the variation magnitude of rotational speed) with the blockage threshold. For different ambient temperatures, the blockage threshold can be set to the same; or can be set differently corresponding to different ambient temperatures. For a case where there is a same blockage threshold, it is referred to as a first blockage threshold in the embodiment. The blockage degree is determined according to the rotational speed as follows: it is determined whether the variation magnitude of rotational speed between the first rotational speed and the second rotational speed is greater than or equal to the first blockage threshold and, if yes, it is determined that the blockage of dust filter is severe. The blockage threshold can be set according to blockage degrees of the dust filter when an alarm is needed. Therefore, the blockage threshold may be divided into a severe blockage threshold and a slight blockage threshold. Specific values of the blockage threshold also need to be set according to the specific blockage degree of the dust filter. When the specific blockage degree is set to be clean or slight blockage, the severe blockage threshold needs to be set relatively large, while the slight blockage threshold can be set smaller. Otherwise, when the specific blockage degree is set to be severe blockage, the severe blockage threshold does not need to be set large, and even can be set as zero. The blockage threshold can be determined experimentally. For example, under a certain temperature, a third rotational speed of the fan, with a clean dust filter, required for enabling the device temperature to reach the target value, and a fourth rotational speed of the fan, with a blocked dust filter to be cleaned, required for enabling the device temperature to reach the target value are detected, and the difference between the fourth rotational speed and the third rotational speed may be set as the blockage threshold. In an embodiment, when the user thinks it is necessary to clean the dust filter, the speed of fan required for enabling the device temperature to reach the target value at this time can be set to the fourth speed.

For a case where there are blockage thresholds corresponding to different ambient temperatures, they are referred to as second blockage thresholds in the embodiment. After the second blockage thresholds are set corresponding to different ambient temperatures, a second correspondence between the ambient temperatures and the second blockage thresholds can be obtained, for example, as shown in following table.

**Table 3**

| Ambient Temperature (degree) | Second Blockage Thresholds (r/s) |
|---|---|
| 35 | 5 |
| 34 | 8 |
| 33 | 9 |
| 32 | 9 |
| 31 | 9 |

As can be seen from above table, in a set of correspondence, the second blockage thresholds corresponding to different ambient temperatures may be the same or different, and this may be set according to actual situation. In the subsequent determination, it is necessary to determine a second blockage threshold based on the current ambient temperature and the second correspondence, so as to determine whether the variation magnitude of rotational speed between the first rotational speed and the second rotational speed is greater than or equal to the determined second blockage threshold and, if yes, it is determined that blockage of the dust filter is severe. Since different target values of device temperature may correspond to different second blockage thresholds in the second correspondence, it is necessary to determine the second blockage threshold based on the current ambient temperature and the established second correspondence after obtaining the variation magnitude of rotational speed. Thereafter, the variation magnitude of rotational speed is compared to the second blockage threshold to determine whether the dust filter needs to be cleaned.

In step S101 described above, an initial rotational speed may be set for the fan. Then, a rotational speed of the fan is adjusted, according to a detected device temperature, gradually from the initial rotational speed until the device temperature is less than or equal to the target value, and the adjusted rotational speed of the fan at this time is set as the first rotational speed. The initial rotational speed may be set in following manners. The initial rotational speed may be set as a fixed value which may be zero. Alternatively, a second rotational speed may be selected as the initial rotational speed according to the current ambient temperature and the first correspondence. Preferably, a rotational speed of the fan, with a clean dust filter, required for enabling the device temperature to reach the target value may be determined, according to the current ambient temperature and the first correspondence, as the initial rotational speed of the fan. After the initial rotation speed is set, the rotational speed of the fan is adjusted, according to the detected device temperature, gradually from the initial rotational speed until the device temperature is less than or equal to the target value, and the adjusted rotational speed of the fan at this time is set as the first rotational speed. Specifically, it may be adjusted in following manner. It is determined whether the device temperature is less than or equal to the target value and, if no, the rotational speed of the fan my be increased step by step from the initial rotation speed until the detected device temperature is lower than or equal to the target value. When the device temperature is lower than or equal to the target value for the first time, the rotational speed of the fan is determined as the first rotational speed of the fan. Thus, when the initial rotational speed of the fan is set as the rotational speed of the fan, with a clean dust filter, required for enabling the device temperature to reach the target value under the current ambient temperature, a detection frequency of the device temperature can be reduced for the fan.

When the second rotational speed is determined as a rotational speed of the fan, with a clean dust filter, required for enabling the device temperature to reach the target value under the current ambient temperature, assuming the dust filter is clean, the fan can enable the device temperature to reach the target value by adjusting its rotational speed as the second rotational speed. If dust is accumulated on the dust filter, however, it may affect cooling effect of the fan applied on the device. Accordingly, the fan cannot enable the device temperature to reach the target value with the second rotational speed when cooling the device. Then the fan will increase the rotational speed for enabling the device temperature to be less than or equal to the target value. The adjusted rotational speed of the fan is the first rotational speed. Control strategy of rotational speed for the fan may be implemented based on a temperature sensitive point within the device. The following is an example to explain adjusting of the rotational speed. Device temperature is detected by the fan at a time interval, so as to determine whether the device temperature is lower than or equal to the target value (if the target value is a range, then determine whether the device temperature is in the range of target value) and, if no, the rotational speed is increased. Thereafter, the device temperature is detected again and, if the device temperature is still greater than the target temperature, the rotational speed is increased again. Such cycle repeats until the device temperature is lower than or equal to the target value. The rotational speed of fan at this time is the first rotational speed of fan.

In order to check blockage of the dust filter in time, it is also possible to detect the actual rotational speed of the fan at a time interval under the current ambient temperature. Then, and the difference between the actual rotational speed of the fan and the second rotational speed is determined to obtain the variation magnitude of actual rotational speed. Thereafter, it is determined whether the variation magnitude of actual rotational speed is greater than or equal to the second severe blockage threshold corresponding to the current environment and, if yes, an alarm is generated. In this way, the rotational speed of the fan is monitored during the speed adjustment of the fan. When the change magnitude of the actual rotation speed relative to the second rotation speed is greater than or equal to the determined second severe blockage threshold, it indicates that blockage of the dust filter is sever and, thus, the dust filter needs to be cleaned. Thus, the user can be promptly informed to clean the dust filter in a timely manner.

In the present embodiment, the rotational speed of fan may be expressed by a characteristic quantity such as rotational speed gear positions or fan control words, as long as the rotational speed of fan can be characterized. When the rotational speed is expressed by the gear positions, the variation magnitude of the first rotational speed of fan with respect to the second rotational speed may be derived by dividing a total number of gear positions by a difference between the gear position corresponding to the first rotational speed and the gear position corresponding to the second rotational speed, and said blockage threshold may be a value. When the rotational speed of fan is indicated by using the gear position, there is no need to provide a dedicated equipment to detect the rotational speed thereof, and it is only required to know the gear position of the fan, making the detection method easier. As to the scheme where the rotational speed of fan is indicated by using the gear position, it will be exemplified in the following third embodiment (referring to the third embodiment).

The ambient temperature in the present embodiment does not refer only to a temperature of environment where the device is located, but also alternatively to a temperature at which the ambient temperature can be characterized, such as a temperature of some objects in the environment where the temperature of the objects varies with the ambient temperature but is invariant with the rotational speed of fan. For example, a temperature of the fan, a temperature detected at the air inlet of the device, a temperature detected at a certain point on a board of the device, or a temperature detected at a certain point on a control panel of the fan may be applicable.

### The Second Embodiment

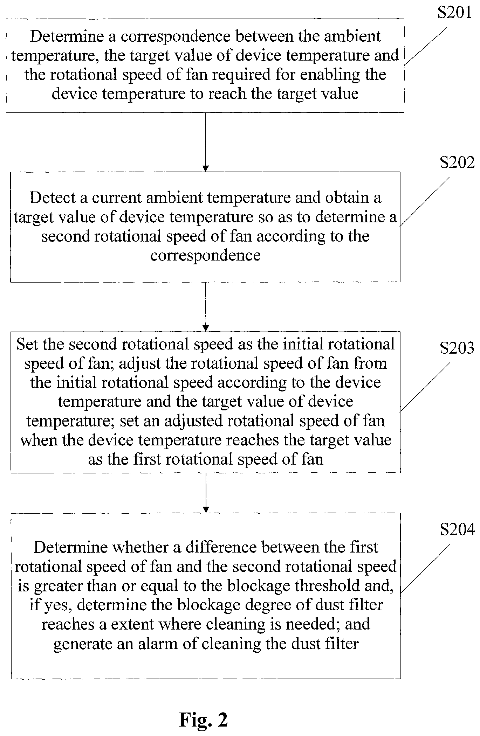

The embodiment provides a detection method of dust filter. The detection method will be described with an example where the certain blockage degree of dust filter is clean and, as shown in Fig. 2, includes following steps.

In step S201, a correspondence between the ambient temperature, the target value of device temperature and the rotational speed of fan required for enabling the device temperature to reach the target value is determined where the dust filter is clean; and a severe blockage threshold is set.

In step S202, a current ambient temperature is detected and a target value of device temperature is obtained so as to determine a second rotational speed of fan according to the correspondence.

In step S203, the second rotational speed is set as the initial rotational speed of fan; the rotational speed of fan is adjusted from the initial rotational speed according to the device temperature and the target value of device temperature and is detected at a time interval; an adjusted rotational speed of fan when the device temperature is less than or equal to the target value is set as the first rotational speed of fan.

In step S204, it is determined whether a difference between the first rotational speed of fan and the second rotational speed is greater than or equal to the severe blockage threshold and, if yes, it is determined the blockage of dust filter is severe and, thus, required to be cleaned. Then, an alarm of cleaning the dust filter is generated.

### The Third Embodiment

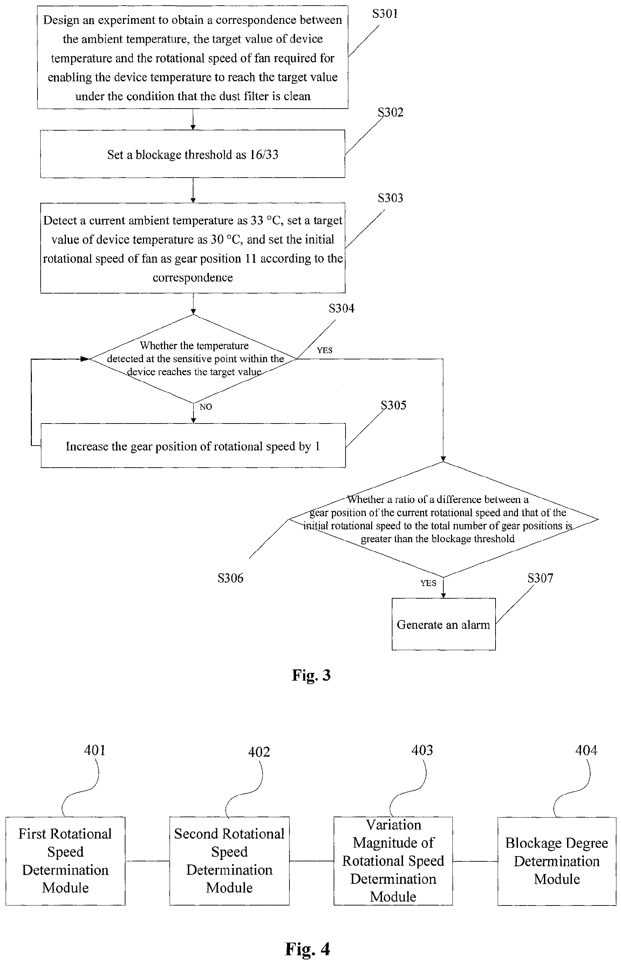

The embodiment provides a method for detecting blockage of dust filter. The method will be described with an example where the certain blockage degree of dust filter is clean and rotational speed of fan is indicated by gear positions. As shown in Fig. 3, the method includes following steps.

In step S301, an experiment is designed to obtain a correspondence between the ambient temperature, the target value of device temperature and the rotational speed of fan required for enabling the device temperature to reach the target value under the condition that the dust filter is clean. Specifically, the target value of device temperature is set to 20 °C. The ambient temperatures are set with 33 values, from 23 °C to 55 °C. The rotational speed of fan is indicated by gear positions; when the ambient temperature is 23 °C, the rotational speed of fan enabling the device temperature to reach 20 °C is set to a lowest position (gear position 1); and when ambient the temperature is 55 °C, the rotational speed of fan enabling the device temperature to reach 20 °C is set to a highest position (gear position 33). When the ambient temperature is between 24 °C and 54 °C, the rotational speed of fan may range from gear position 2 to 32 and correspond there to one by one. Thus, there are a total of 33 correspondences. Although there is a one-to-one correspondence between the ambient temperature and the rotational speed of fan, the rotational speed is not adjusted based on the ambient temperature, but according to a temperature sensitive point within the device.

In step S302, a blockage threshold is set as 16/33.

In step S303, a current ambient temperature is detected as 33 °C (If the ambient temperature falls between an upper and lower adjacent temperatures, it may be taken as the lower adjacent temperature. For example, when the ambient temperature is 23.6 °C, falling between 23 °C and 24 °C, it may be taken as 23 °C). The target value of device temperature is set as 20 °C, so the initial rotational speed of fan is set as gear position 11 according to the correspondence mentioned above.

In step S304, it is determined whether the temperature detected at the sensitive point within the device reaches the target value, if no, step S305 is performed and, if yes, step S306 is performed.

In step S305, the gear position of rotational speed is increased by 1 and, then, step S304 is performed.

In step S306, it is determined whether a ratio of a difference between a gear position of the current rotational speed and that of the initial rotational speed to the total number of gear positions is greater than the blockage threshold, if yes, step S307 is performed and, if no, no process is performed.

In step S307, an alarm is generated.

In the present embodiment, when the ambient temperature falls between 23 °C and 39 °C, the maximum difference between a gear position of the current rotational speed and that of the initial rotational speed may be 16, an effective alarm of blockage of dust filter can be carried out.

In this embodiment, the blockage threshold is set to 16/33, but it can be adjusted according to actual needs. It is recommended that the blockage threshold is not less than 16/33 and not more than 24/33. If it is desired to predict the blockage of dust filter earlier, so as to reserve enough time for maintenance, the threshold may be set to be small. If it is desired to keep longer time before next maintenance of the dust filter, the threshold may be set to be great so as to carry out maintenance in time.

In addition, for a larger ambient temperature, the blockage threshold can be set smaller. For example, when the ambient temperature is 45 °C, there are 23 gear positions corresponding thereto. So, it may cause a problem if blockage of dust filter is only alerted until the variation magnitude is 16 gear positions as there are a total number of 23 gear positions. Therefore, the threshold may be set to 1/4 for this case.

### The Fourth Embodiment

The embodiment provides a system for detecting blockage of dust filter. Referring to Fig. 4, the system includes a first rotational speed determination module 401, a second rotational speed determination module 402, a variation magnitude of rotational speed determination module 403, and a blockage degree determination module 404. The first rotational speed determination module 401 is configured to detect a first rotational speed of a fan enabling a device temperature to reach a target value under a current ambient temperature. The second rotational speed determination module 402 is configured to determine a second rotational speed of the fan, with a certain blockage degree of the dust filter, required for enabling the device temperature to reach the target value under the current ambient temperature. The variation magnitude of rotational speed determination module 403 is configured to determine a difference between the first rotational speed and the second rotational speed, so as to obtain a variation magnitude of rotational speed. The blockage degree determination module 404 is configured to determine a current blockage degree of the dust filter according to the variation magnitude of rotational speed.

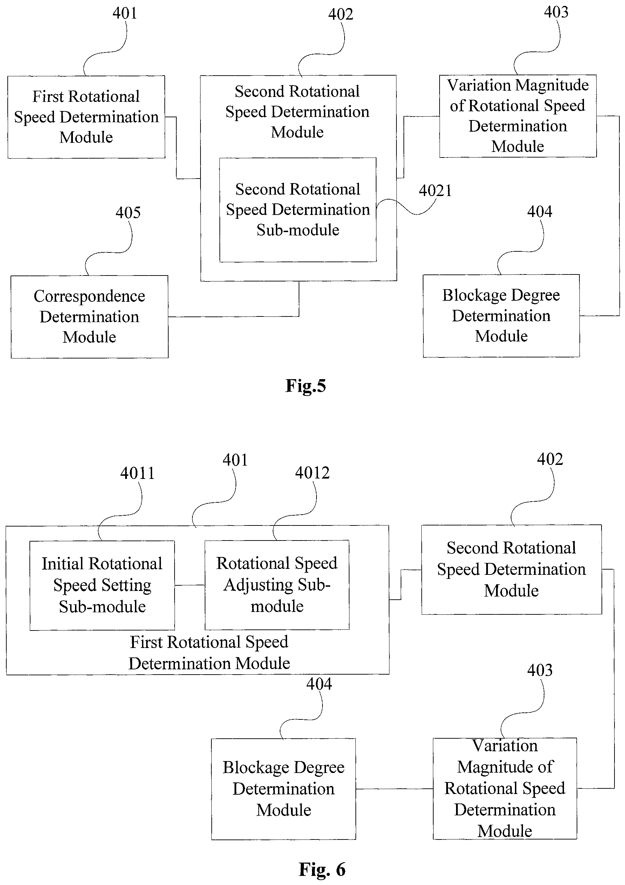

In the embodiment, the system further includes a first correspondence determination module 405, as shown Fig. 5. The first correspondence determination module 405 is configured to detect rotational speeds of the fan, with the certain blockage degree of the dust filter, required for enabling the device temperature to reach the target value under different ambient temperatures, so as to obtain a first correspondence between the ambient temperatures and the rotational speeds of the fan. The second rotational speed determination module 402 includes a second rotational speed determination sub-module 4021 configured to determine, according to the current ambient temperature and the first correspondence, a rotational speed of the fan, with the certain blockage degree of the dust filter, required for enabling the device temperature to reach the target value as the second rotational speed.

In the embodiment, the first rotational speed determination module 410 may further include an initial rotational speed setting sub-module 4011 and a rotational speed adjusting sub-module 4012, as shown in Fig. 6. The initial rotational speed setting sub-module 4011 is configured to set an initial rotational speed of the fan. The rotational speed adjusting sub-module 4012 is configured to adjust, according to a detected device temperature, a rotational speed of the fan gradually from the initial rotational speed until the device temperature is less than or equal to the target value, and determine the adjusted rotational speed of the fan as the first rotational speed. The initial rotational speed setting sub-module 4011 includes a first initial rotational speed setting sub-module or a second initial rotational speed setting sub-module. The first initial rotational speed setting sub-module is configured to set a fixed value as the initial rotational speed. The second initial rotational speed setting sub-module is configured to determine, according to the current ambient temperature and the first correspondence, a rotational speed of the fan, with a clean dust filter, required for enabling the device temperature to reach the target value as the initial rotational speed of the fan.

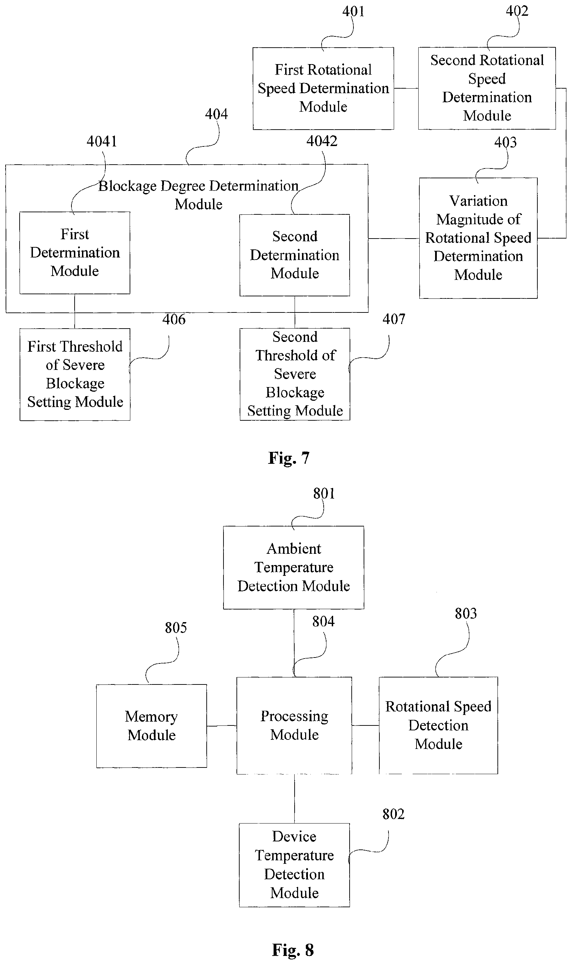

In the embodiment, the system further includes a first threshold of severe blockage setting module 406, as shown in Fig. 7. The first threshold of severe blockage setting module 406 is configured to set a first threshold of severe blockage for different ambient temperatures. The blockage degree determination module 404 includes a first determination module 4041 configured to detect whether the variation magnitude of rotational speed is greater than or equal to the first threshold of severe blockage and, if yes, determine that the blockage degree of the dust filter is severe. The system may further include a second threshold of severe blockage setting module 407 configured to set second thresholds of severe blockage respectively for different ambient temperatures, so as to obtain a second correspondence between the ambient temperatures and the second thresholds of severe blockage. The blockage degree determination module 404 includes a second determination module 4042 configured to determine a second threshold of severe blockage according to the current ambient temperature and the second correspondence, detect whether the variation magnitude of rotational speed is greater than or equal to the second threshold of severe blockage and, if yes, determine that the blockage degree of the dust filter is severe.

### The Fifth Embodiment

The embodiment provides an apparatus for detecting blockage of dust filter. Referring to Fig. 8, the apparatus includes an ambient temperature detection module 801, a device temperature detection module 802, a rotational speed detection module 803, a processing module 804, and a memory module 805. The ambient temperature detection module 801 is configured to detect a current ambient temperature. The device temperature detection module 802 is configured to detect a device temperature. The rotational speed detection module 803 is configured to detect a rotational speed of a fan. The device temperature detection module 802 is further configured to notify the processing module 804 when the detected device temperature reaches a target value. The processing module is configured to acquire a current rotational speed from the rotational speed detection module, and set the current rotational speed as a first rotational speed. The memory module 805 is configured to store a correspondence between a second rotational speed and an ambient temperature, the second rotational speed being a rotational speed of the fan, with a certain blockage degree of the dust filter, required for enabling the device temperature to reach the target value. The processing module 804 is further configured to acquire the current ambient temperature from the ambient temperature detection module, and acquire a second rotational speed of the fan corresponding to the current ambient temperature from the memory module. The processing module 804 is further configured to determine a difference between the first rotational speed and the second rotational speed, obtain a variation magnitude of rotational speed according to the difference, and determine a current blockage degree of the dust filter according to the variation magnitude of rotational speed.

In the embodiment, the memory module 805 is further configured to store a first threshold of severe blockage and/or a second threshold of severe blockage. The first threshold of severe blockage is set as a same value for different ambient temperatures. The processing module 804 is further configured to acquire the first threshold of severe blockage from the memory module 805, and detect whether the variation magnitude of rotational speed is greater than or equal to the first threshold of severe blockage and, if yes, determine that the blockage degree of the dust filter is severe. The second threshold of severe blockage is set as values corresponding to different ambient temperatures. The processing module 804 is further configured to acquire a second threshold of severe blockage corresponding to the current ambient temperature from the memory module 805 after acquiring the current ambient temperature, and detect whether the variation magnitude of rotational speed is greater than or equal to the second threshold of severe blockage and, if yes, determine that the blockage degree of the dust filter is severe.

The abovementioned embodiments are merely preferred embodiments of the present disclosure rather than restriction on implementation of the disclosure. It shall be pointed out that to those of ordinary skill in the art, various inference and substitution may be made without departing from the principle of the present disclosure, and should be deemed to fall within the protection scope of the present disclosure.

It will be appreciated by those of ordinary skill in the art that all or a portion of the steps of the above-described embodiments may be implemented using computer program flow, which may be stored in a computer-readable storage medium. The computer program may be executed on a corresponding hardware platform (e.g. systems, devices, apparatuses, equipment, etc.) and, when being executed, may include one or a combination of the steps described in the embodiment of method.

Alternatively, all or a portion of the steps of the embodiments described above may also be implemented using integrated circuits, which may be individually fabricated as several separate integrated circuit modules or as a single integrated circuit module to perform a plurality of modules or steps. Thus, the present invention is not limited to any particular combination of hardware and software.

The various devices/functional modules/functional units in the embodiments described above may be implemented using general purpose computing devices, which may be centralized on a single computing device or distributed over a network of computing devices.

The various devices/functional modules/ functional units in the above embodiments may be implemented in the form of software function modules and can be stored in a computer-readable storage medium when sold or used as a standalone product. The above-mentioned computer-readable storage medium may be a read-only memory, a magnetic disk, an optical disk, or the like.

### INDUSTRIAL APPLICABILITY

The solution provided by embodiments of the disclosure is simple in structure and low in cost as well as wide in application scope.

## Claims

1. A method for detecting blockage of a dust filter, comprising:
detecting a first rotational speed of a fan enabling a device temperature to reach a target value under a current ambient temperature;
determining a second rotational speed of the fan, with a certain blockage degree of the dust filter, required for enabling the device temperature to reach the target value under the current ambient temperature;
determining a difference between the first rotational speed and the second rotational speed, so as to obtain a variation magnitude of rotational speed according to the difference; and
determining a current blockage degree of the dust filter according to the variation magnitude of rotational speed.

2. The method for detecting blockage of a dust filter according to claim 1, wherein,
before the detecting a first rotational speed of a fan enabling a device temperature to reach a target value under a current ambient temperature, the method comprises: detecting rotational speeds of the fan, with the certain blockage degree of the dust filter, required for enabling the device temperature to reach the target value under different ambient temperatures, so as to obtain a first correspondence between the ambient temperatures and the rotational speeds of the fan; and
the determining a second rotational speed of the fan, with a certain blockage degree of the dust filter, required for enabling the device temperature to reach the target value under the current ambient temperature comprises: determining, according to the current ambient temperature and the first correspondence, a rotational speed of the fan, with the certain blockage degree of the dust filter, required for enabling the device temperature to reach the target value as the second rotational speed.

3. The method for detecting blockage of a dust filter according to claim 1 or 2 wherein, the certain blockage degree is any one selected from a range from clean to complete blockage.

4. The method for detecting blockage of a dust filter according to claim 2, wherein, the detecting a first rotational speed of a fan enabling a device temperature to reach a target value under a current ambient temperature comprises:
setting an initial rotational speed of the fan, adjusting, according to a detected device temperature, a rotational speed of the fan gradually from the initial rotational speed until the device temperature is less than or equal to the target value, and determining the adjusted rotational speed of the fan as the first rotational speed.

5. The method for detecting blockage of a dust filter according to claim 4, wherein, the setting an initial rotational speed of the fan comprises: setting a fixed value as the initial rotational speed; or determining, according to the current ambient temperature and the first correspondence, a rotational speed of the fan, with a clean dust filter, required for enabling the device temperature to reach the target value as the initial rotational speed of the fan.

6. The method for detecting blockage of a dust filter according to claim 3, wherein, before the determining a current blockage degree of the dust filter according to the variation magnitude of rotational speed, the method comprises: setting a first threshold of severe blockage for different ambient temperatures;
the determining a current blockage degree of the dust filter according to the variation magnitude of rotational speed comprises: detecting whether the variation magnitude of rotational speed is greater than or equal to the first threshold of severe blockage and, if yes, determining that the blockage degree of the dust filter is severe.

7. The method for detecting blockage of a dust filter according to claim 3, wherein, before the determining a current blockage degree of the dust filter according to the variation magnitude of rotational speed, the method comprises: setting second thresholds of severe blockage respectively for different ambient temperatures, so as to obtain a second correspondence between the ambient temperatures and the second thresholds of severe blockage;
the determining a current blockage degree of the dust filter according to the variation magnitude of rotational speed comprises: determining a second threshold of severe blockage according to the ambient temperature and the second correspondence, detecting whether the variation magnitude of rotational speed is greater than or equal to the second threshold of severe blockage and, if yes, determining that the blockage degree of the dust filter is severe.

8. The method for detecting blockage of a dust filter according to claim 7, wherein, before the detecting a first rotational speed of a fan enabling a device temperature to reach a target value under a current ambient temperature, the method comprises: detecting an actual rotational speed of the fan at a time interval under the current ambient temperature;
after the determining a second rotational speed of the fan, with a certain blockage degree of the dust filter, required for enabling the device temperature to reach the target value under the current ambient temperature, the method comprises: determining a difference between the actual rotational speed of the fan and the second rotational speed, so as to obtain an actual variation magnitude of rotational speed; detecting whether the variation magnitude of actual rotational speed is greater than or equal to the second threshold of severe blockage corresponding to the current ambient temperature and, if yes, determining that the blockage of the dust filter is severe.

9. A system for detecting blockage of a dust filter, comprising: a first rotational speed determination module, a second rotational speed determination module, a variation magnitude of rotational speed determination module, and a blockage degree determination module;
the first rotational speed determination module is configured to detect a first rotational speed of a fan enabling a device temperature to reach a target value under a current ambient temperature;
the second rotational speed determination module is configured to determine a second rotational speed of the fan, with a certain blockage degree of the dust filter, required for enabling the device temperature to reach the target value under the current ambient temperature;
the variation magnitude of rotational speed determination module is configured to determine a difference between the first rotational speed and the second rotational speed, so as to obtain a variation magnitude of rotational speed according to the difference;
the blockage degree determination module is configured to determine a current blockage degree of the dust filter according to the variation magnitude of rotational speed.

10. The system for detecting blockage of a dust filter according to claim 9, wherein, the system further comprises a first correspondence determination module configured to detect rotational speeds of the fan, with the certain blockage degree of the dust filter, required for enabling the device temperature to reach the target value under different ambient temperatures, so as to obtain a first correspondence between the ambient temperatures and the rotational speeds of the fan;
the second rotational speed determination module comprises a second rotational speed determination sub-module configured to determine, according to the current ambient temperature and the first correspondence, a rotational speed of the fan, with the certain blockage degree of the dust filter, required for enabling the device temperature to reach the target value as the second rotational speed.

11. The system for detecting blockage of a dust filter according to claim 10, wherein, the first rotational speed determination module comprises an initial rotational speed setting sub-module and a rotational speed adjusting sub-module;
the initial rotational speed setting sub-module is configured to set an initial rotational speed of the fan;
the rotational speed adjusting sub-module is configured to adjust, according to a detected device temperature, a rotational speed of the fan gradually from the initial rotational speed until the device temperature is less than or equal to the target value, and determine the adjusted rotational speed of the fan as the first rotational speed.

12. The system for detecting blockage of a dust filter according to claim 11, wherein,
the initial rotational speed setting sub-module comprises a first initial rotational speed setting sub-module or a second initial rotational speed setting sub-module, the first initial rotational speed setting sub-module is configured to set a fixed value as the initial rotational speed; and the second initial rotational speed setting sub-module is configured to determine, according to the current ambient temperature and the first correspondence, a rotational speed of the fan, with a clean dust filter, required for enabling the device temperature to reach the target value as the initial rotational speed of the fan.

13. The system for detecting blockage of a dust filter according to claim 12, the system further comprises a first threshold of severe blockage setting module configured to set a first threshold of severe blockage for different ambient temperatures;
the blockage degree determination module comprises a first determination module configured to detect whether the variation magnitude of rotational speed is greater than or equal to the first threshold of severe blockage and, if yes, determine that the blockage degree of the dust filter is severe.

14. The system for detecting blockage of a dust filter according to claim 12, wherein, the system further comprises a second threshold of severe blockage setting module configured to set second thresholds of severe blockage respectively for different ambient temperatures, so as to obtain a second correspondence between the ambient temperatures and the second thresholds of severe blockage;
the blockage degree determination module comprises a second determination module configured to determine a second threshold of severe blockage according to the ambient temperature and the second correspondence, detect whether the variation magnitude of rotational speed is greater than or equal to the second threshold of severe blockage and, if yes, determine that the blockage degree of the dust filter is severe.

15. An apparatus for detecting blockage of a dust filter, comprising: an ambient temperature detection module, a device temperature detection module, a rotational speed detection module, a processing module, and a memory module;
the ambient temperature detection module is configured to detect a current ambient temperature;
the device temperature detection module is configured to detect a device temperature;
the rotational speed detection module is configured to detect a rotational speed of a fan;
the device temperature detection module is further configured to notify the processing module when the detected device temperature reaches a target value; and the processing module is configured to acquire a current rotational speed from the rotational speed detection module, and set the current rotational speed as a first rotational speed;
the memory module is configured to store a correspondence between a second rotational speed and an ambient temperature, the second rotational speed being a rotational speed of the fan, with a certain blockage degree of the dust filter, required for enabling the device temperature to reach the target value; the processing module is further configured to acquire the current ambient temperature from the ambient temperature detection module, and acquire a second rotational speed of the fan corresponding to the current ambient temperature from the memory module;
the processing module is further configured to determine a difference between the first rotational speed and the second rotational speed, obtain a variation magnitude of rotational speed according to the difference, and determine a current blockage degree of the dust filter according to the variation magnitude of rotational speed.

16. The device for detecting blockage of a dust filter according to claim 15, wherein, the memory module is further configured to store a first threshold of severe blockage and/or a second threshold of severe blockage;
the first threshold of severe blockage is set as a same value for different ambient temperatures; the processing module is further configured to acquire the first threshold of severe blockage from the memory module, and detect whether the variation magnitude of rotational speed is greater than or equal to the first threshold of severe blockage and, if yes, determine that the blockage degree of the dust filter is severe;
the second threshold of severe blockage is set as values corresponding to different ambient temperatures; the processing module is further configured to acquire a second threshold of severe blockage corresponding to the current ambient temperature from the memory module after acquiring the current ambient temperature, and detect whether the variation magnitude of rotational speed is greater than or equal to the second threshold of severe blockage and, if yes, determine that the blockage degree of the dust filter is severe.
